# EUROPEAN PATENT SPECIFICATION

(11) **EP 3 852 269 B1**
(45) Date of publication and mention of the grant of the patent: **04.03.2026**
(21) Application number: 19859361.8
(22) Date of filing: 12.09.2019
(51) Int. Cl.: H03C 1/00, H03D 1/00, H03C 1/52, H04L 27/04, H04L 27/06

(54) **SYNCHRONOUS MODULATION SYSTEM USING AMPLITUDE MODULATION**
SYNCHRONES MODULATIONSSYSTEM MIT AMPLITUDENMODULATION
SYSTÈME SYNCHRONE DE MODULATION D'AMPLITURE MODULÉE

(30) Priority: 12.09.2018 MX 2018011028
(43) Date of publication of application: 21.07.2021
(73) Proprietor: Díaz Pier, Marissa, Estado de México, 52938 (MX); Diaz Arias, Herman, Estado de México, 52938 (MX)
(72) Inventor: Díaz Pier, Marissa, Estado de México, 52938 (MX); Diaz Arias, Herman, Estado de México, 52938 (MX)
(74) Representative: Gallego Jiménez, José Fernando
(86) International application number: PCT/MX2019/000098
(87) International publication number: WO 2020/055227

(56) References cited:
- WO-A1-91/03899
- US-B1- 6 421 393
- US-B2- 8 737 516
- US-B2- 8 737 516
- US-B2- 9 768 733

## Description

### Field of the invention

This invention is developed mainly in the fields of Electronic Engineering and Telecommunications Engineering, since it is an equipment that allows the transmission of information and signals through various media, using a carrier wave and an original modulation system.

### Background of the invention

Throughout the 20th century and so far in the 21st century, various methods and systems have been developed to send information from one point to another over long distances, generally using wired or wireless 15 means, however, the need to make multiple simultaneous transmissions avoiding that the information of each of the transmissions gets mixed with or corrupted by the interaction with other signals, has led to the use of a base signal or carrier frequency that allows a first and basic differentiation between several signals traveling on the same medium the most basic and traditional are amplitude modulation (AM) and frequency modulation (FM), which have been followed by systems such as FSK, PPM, OOK, and others.

There is a fundamental law in communications theory that states that the frequency of the carrier or carrier signal must be at least twice the maximum frequency of the information signal or modulating signal; this establishes a theoretical barrier to the design of telecommunication systems and limits the amount of information per second or the system rate. To send more information in a certain frequency band, even combinations of amplitude modulation with frequency modulation have been used, however, this type of signal processing produces secondary harmonics that widen the required bandwidth.

All traditional systems, such as those mentioned above, abide by the limiting two-to-one law mentioned above, obeying this basic law of telecommunications; our system proposes a modulation and demodulation alternative, which we have proven to bypass this fundamental law, making possible the transmission of much higher frequency signals using carriers of even half the frequency of the information.

Document US 6,421,393 B1 discloses a method and system for combining multiple individual asynchronous data streams for simultaneous transmission in the analog domain via a single conductor or wireless transmission medium. In one embodiment, a carrier signal is modulated and demodulated on a half-cycle basis. Each half-cycle is amplitude modulated (i.e., multiplied) by a fixed value representative of the data to be encoded that is applied to the half-cycle at zero-crossing and is held steady for the duration of the half-cycle. In this manner, each half-cycle of a carrier signal is modulated to contain data. For purposes of redundancy or security, two or more half-cycles may be used to contain the data, but in each case, the modulation still occurs on a half-cycle basis.

Document US 8,737,516 B2 discloses a method and system is provided for communicating distinct data over a single frequency using on-of fkeying, a form of amplitude modulation, or phase changes timed to the zero crossing point of the carrier. A data signal is synchronized with the carrier by adding padding bits so that the number of bits is equal to the frequency of the carrier. The carrier is then modified by attenuating the carrier as needed once per cycle. Said carrier is then transmitted. The resulting transmitted carrier carries a number of bits equal to the transmit frequency. At the receive end, the received signal is compared to a sine wave to determine if the incoming signal is at full strength or at reduced strength, allowing for the detection of encoded digital information. In another embodiment, the phase of the carrier is changed instead of attenuating the carrier, timed to the carrier cycles, once or twice per cycle.

### Brief description of the invention

The system proposed by our design is a modulator and a demodulator according to the invention as defined in claim 1 that work based on an amplitude modulation but sending different information in the positive and negative part of the sine wave used as a carrier, by performing this type of modulation, our system can send information at a frequency "2f", using a carrier with frequency "f", at first glance, this is incompatible with the fundamental law of telecommunications that states that the carrier frequency must be at least twice the maximum modulation frequency, nonetheless, in this case, we are managing to transmit information four times faster than the rate established by the theory.

The system is especially useful for sending digital information serially using an AM band, and the transport medium can be either wired or wireless, likewise, this design avoids the generation of excessive harmonics, allowing its operation within a limited bandwidth, contrary to what usually happens with other systems such as the OOK, which generates numerous harmonics, and its apparent transmission is a signal with a very broad spectrum. The modulation and demodulation in our system allow a wide margin of safety against noise and the ease of identifying synchronization points.

The essential elements of our system are the modulator and demodulator, which can be connected to other traditional elements of telecommunication systems such as amplifiers, power units and antennas or interfaces for cable transmission, to integrate a complete bidirectional telecommunication system.

### Description of the figures

Figure 1 shows a typical carrier signal and a typical modulating signal.
Figure 2 shows a signal modulated by means of the system and the information it carries.
Figure 3 shows the modulator circuit according to the invention.
Figure 4 shows a diagram of the telecommunication receiver.
Figure 5 shows the demodulator circuit according to the invention.
Figure 6 shows a complete communication system, including the modulator and the demodulator.
Figure 7 shows the diagram of the zero-centered circuit.

### Detailed description of the invention

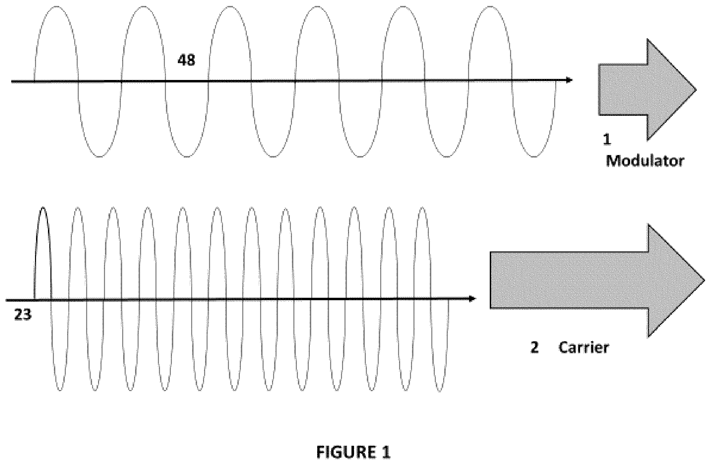

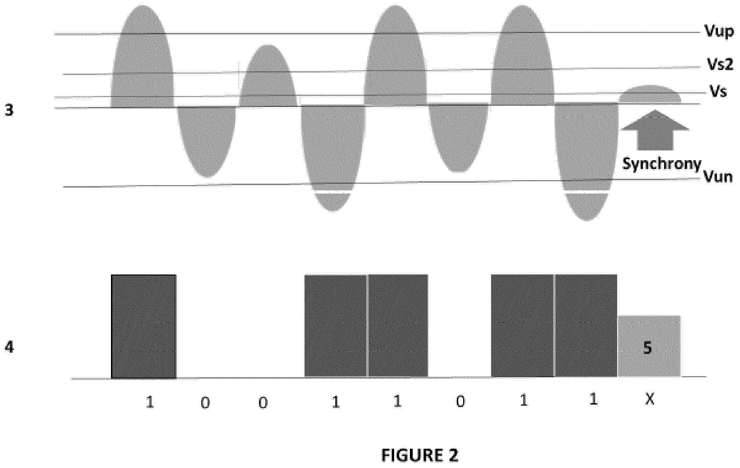

The synchronous modulation system using amplitude modulation object of the present invention as defined in claim 1 is distinguished from other systems by the fact that it can handle transmitted signal frequencies equal to twice the carrier frequency; the system uses a modulator formed by a microcontroller in charge of controlling a set of attenuators that can be programmed to generate a certain degree of attenuation to both the positive and the negative part of a signal used as carrier and, as a counterpart, it has a demodulator that can accurately detect the attenuation levels imposed on each half cycle of oscillation of the carrier signal, this modulator and demodulator assembly forms the basis of this design and allows the transmission of serial digital signals at higher speeds than the carrier itself, the hybrid nature of this design lies in the combined use of analog and digital electronics within the modulation and demodulation processes, and can be easily used to integrate wired, wireless, or optical telecommunication systems; as illustrated in figure 1, in traditional systems, a carrier (2) with a carrier frequency (23) is used as the basis of transmission, while the modulating signal (1) may have a modulating frequency (48), no greater than half the carrier frequency (23). The technique that is the basis for our design consists of using the carrier signal in such a way that it is possible to send different pieces of information, one in the positive part of the carrier and the other in the negative part, this technique mixes an analogical treatment of the signal with a digital treatment and, unlike systems like OOK, very few parasitic harmonics are generated, which contributes to the use of a narrow frequency band for the transmissions, in figure 2 the basic principle of our system can be appreciated: the information (4) train, consisting of a series of ones and zeros (serial information), to which a synchrony signal (5) has been added, is used to modulate a sine signal that constitutes the carrier, the synchrony signal (5) is included inside the serial information (4) train, so that when demodulating the signal, it is possible to identify the start and end of a certain text, page, or graphics. The modulated signal (3) shows that the carrier is modulated in such a way that within it there is distinguishable information in both the positive and negative parts of the signal, ones and zeros are characterized within this signal, 5 according to amplitude, whether or not some preset levels of amplitude, both positive and negative, are exceeded. Vup will be the minimum magnitude of amplitude that defines a one, and Vun will be relate to the wave negative part, when the lobe or the sinusoidal signal does not exceed these levels, it will be considered a zero, likewise, it is possible to generate a synchrony signal (5), which is characterized by exceeding the Vs level, without exceeding the Vup level; in figure 2, the space between the zero level or reference level and the sinusoidal signal has been shaded for clarity, but it will be considered a one in so far as the sinusoidal signal exceeds the Vup level in its positive part or the Vun level in its negative part.

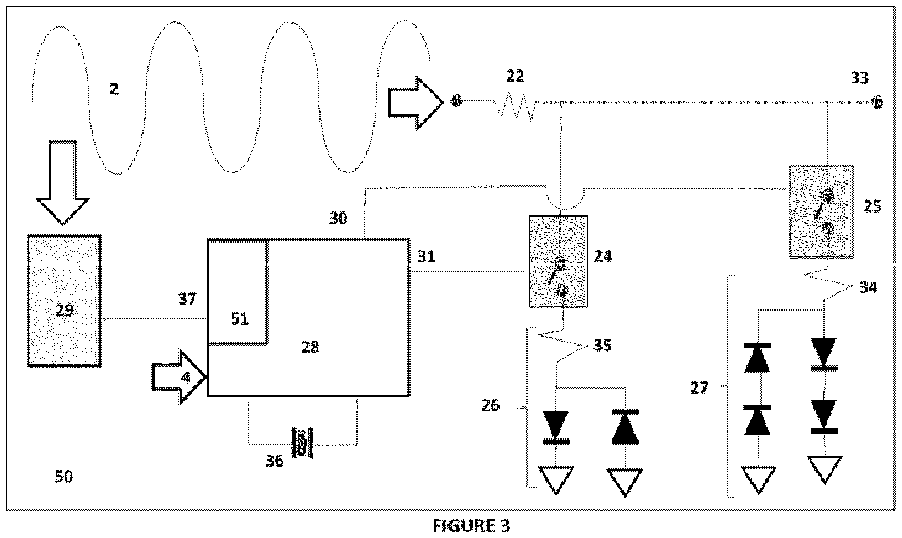

Figure 3 shows a circuit used to perform this type of modulation, in this diagram, a frequency carrier is processed to produce a signal like the modulated signal (3) in figure 2, a zerocrossing detector (29) allows to establish a proper synchrony between the frequency (23) of the carrier (2) and the information (4) serial train, the output of the zero-crossing detector (29) is connected to the phasing input (37) of the modulation microcontroller (28), equipped with a modulation crystal (36), which allows the information (4) frequencies and the carrier frequency (23) to remain always in agreement and in phase as a time reference; the modulation microcontroller (28) also has a zero-control output (30) and a synchrony control output (31), for each half cycle of the carrier, when the carrier is required to represent a ONE, the modulation microcontroller (28) will do nothing until the end of this half period, but when it is required to mark a ZERO in this half cycle, the modulation microcontroller (28) will send a signal to the zero-control output (30), which will cause the zero switch (25) to close, forming a voltage divider with the limiting resistor (22) and the zero attenuator assembly (27), which will determine that, for this half cycle, the sinusoidal signal of the carrier will be attenuated to a level of magnitude lower than Vup or Vun, depending on whether it is a carrier positive or negative half cycle (see figure 2); the zero-limiting resistor (34) makes smoother the cut-off of the resulting signal at the modulated output (33) point, without this resistor, the carrier sinusoidal signal would be cut off, forming a plateau of plus or minus two bias voltages in a diode, (0.7 for a silicon diode), thus, by including the zero-limiting resistor (34), the modulated output (33) signal acquires a more rounded shape, that is, with fewer harmonics; when wanting to mark a sync signal (5), the modulating microcontroller (28) sends a signal to the sync control output (31), which momentarily closes the sync switch (24), this procedure is like the one described for the implementation of a ZERO, but in this case the attenuation is higher, producing an output signal with a higher magnitude than the Vs level but lower than the Vs2 level in figure 2, ensuring that the synchrony signal can be identified by differentiating it from a ONE or a ZERO, in this case, the proper attenuation is achieved by the action of the synch attenuator assembly (26), which includes the synch-limiting resistor (35), this assembly works similarly to the zero-attenuator assembly (27) but, since it has fewer diodes in series, the attenuation is higher. The switches (24) and (25), as well as the resistor (22) and the assemblies (26) and (27), constitute programmable attenuators that allow attenuating the signal of the carrier (2) in a synchronous and programmable way to perform the modulation.

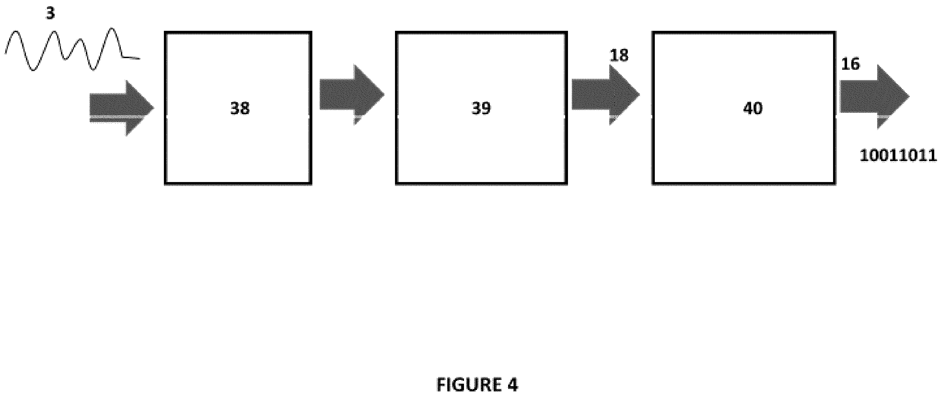

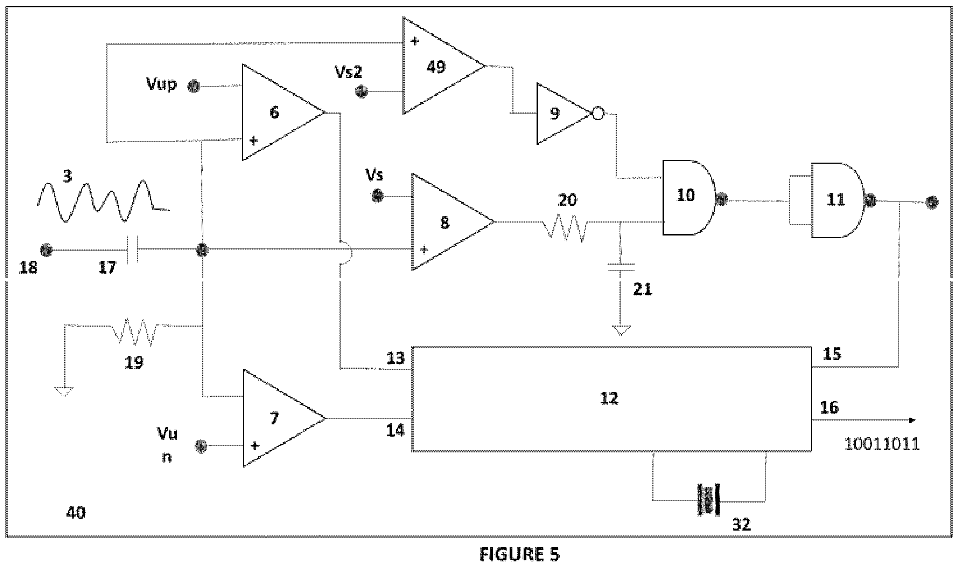

Figure 4 shows a block diagram of the demodulation circuits, this diagram shows how a modulated signal (3) is introduced to an automatic gain control (38) and then to a zero centered circuit (39) both circuits are essential for the correct demodulation of the signal, the automatic gain control (38) is a conventional circuit that ensures that the output signal has a predetermined magnitude from peak to peak, while the zero-centering circuit (39) is responsible for centering the signal based on the positive and negative peak values, a simple arrangement of capacitor and resistor cannot perform this task successfully, since the centering that this type of circuit produces is based on the amount of energy or the area from the curve to the reference axis, balancing this magnitude in positive and negative sense, but this does is useless to demodulate the signal according to how it was modulated, the signal input (18) to the demodulator (40) must be perfectly centered with respect to the signal maximum positive value and maximum negative value, so that the circuit of figure 5 can be applied to synchronize and demodulate the signal; as shown in the diagram in figure 5, the modulated signal (3), which has been previously centered, is applied to the signal input (18) coupled by the input capacitor (17) and the resistor (19) in such a way that this signal is applied to the positive inputs of the positive comparator (6), of the synchrony comparator (8) and of the secondary comparator (49) as well as to the negative input of the negative comparator (7), this set of ultra-high-speed comparators act in such a way that if the signal exceeds the magnitude of the Vup or the Vun level, the corresponding outputs will give this information to the demodulation microcontroller (12) through the one positive input (13) or the one negative input (14), if none of these levels is exceeded neither positively nor negatively, the demodulation microcontroller (12) will determine that the signal corresponding to this half period of the signal is a ZERO, if either of the two levels (Vup or Vun) is exceeded, the signal corresponding to this half period will be a ONE; meanwhile, if the synchrony comparator (8) detects that the signal has exceeded the Vs level (positive), it will determine that the output of the synchrony comparator (8) presents a ONE and the delay capacitor (21) will start to get charged through the delay resistor (20), this delay is necessary to differentiate a synchrony signal from a ONE or a ZERO, since a ONE or a ZERO would exceed the Vs2 level, causing the secondary comparator (49) to present an output of ONE at the input of the inverter (9) whose output will consequently be a ZERO, determining that the output of the NAND gate (10) remains at ONE regardless of the output of the synchrony comparator (8), causing the output of the gate (11) to remain at ZERO, this is the signal of the synchrony input (15) of the demodulation microcontroller (12), indicating that what was received was a ONE or a ZERO and not a synchrony signal, since a ONE will only be registered in the synchrony input (15) when there is a true synchrony signal; a demodulation crystal (32) allows the demodulation microcontroller (12) to verify the synchrony status with the modulated signal (3), as a time reference, which allows the demodulation microcontroller (12) to present the transmitted serial information in its output (16).

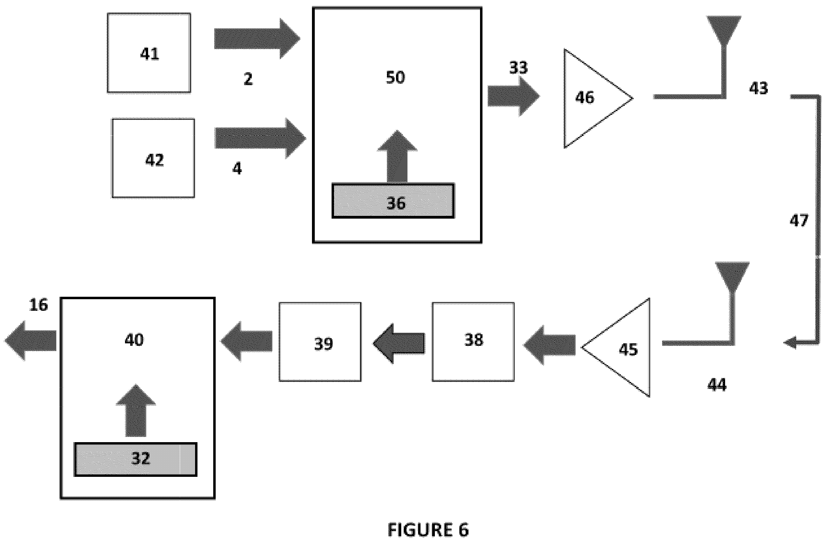

This modulation and demodulation method allows the easy integration of a complete telecommunication system as shown in figure 6, where an oscillator (41) and a serial information generator (42) provide a carrier (2) and a digital serial information (4) to a modulator circuit (50) as the one presented in figure 3, the modulated output (33) is sent to a power amplifier (46) so that, from there, it can be derived to a transmitting antenna for a wireless transmission (43) or a cable (47) for a wired transmission; reception is achieved through the action of a receiving antenna (44) or a communication cable (47), an input amplifier (45) amplifies the signal to levels suitable for handling, while an automatic gain control (38) is responsible for maintaining the peak-to-peak signal with a minimum variation with respect to a preset magnitude so that the zero-centered circuit (39) can present the signal in the necessary format to the demodulator (40) as shown in figure 5, and thus obtain the corresponding output (16).

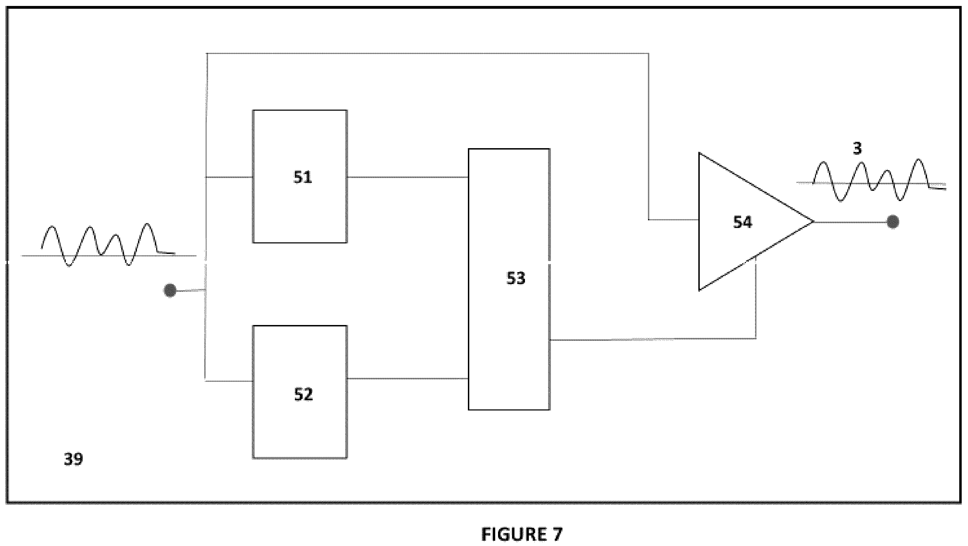

Figure 7 shows the block diagram of the zero-centered circuit (39) with a positive rectifier (51), a negative rectifier (52) and a zeroing microcontroller (53), which determines the maximum positive and negative values of the input signal and, based on this, manipulates the DC balance of an adjustable level amplifier (54) so that the output of the zero-centered circuit constitutes the input signal to the demodulator, but now perfectly centered with respect to the signal maximum and minimum values.

The essential element for the correct operation of this modulator system, capable of transmitting information at frequencies twice the carrier frequency (four times the maximum indicated by the telecommunications theory), is the synchronization between the information and the carrier, to achieve this, the modulation synchronizer circuit (51), which works closely with the modulation microcontroller (28), as shown in figure 3, is essential to avoid the generation of harmonics that corrupt the information.

## Claims

1. A synchronous modulation system using amplitude modulation comprising a modulator (50) and a demodulator (40);
wherein the modulator (50) comprises:
a modulation microcontroller (28) connected to a synchronizer (51) configured to phase and synchronize an information (4) serial train of ONES and ZEROS with respect to a sinusoidal carrier signal (2) having positive and negative half cycles to generate a modulated signal (3), wherein the modulation microcontroller (28) is further configured to control a set of programmable attenuators (26, 27) configured to associated each ONE and each ZERO with a positive or a negative half of the carrier signal (2);
a zero-crossing detector (29), wherein an output of the zero-crossing detector (29) is connected to a phasing input (37) of the modulation microcontroller (28) to synchronize a frequency (23) of the carrier signal (2) and the information (4) serial train input to the modulation microcontroller (28);
a zero-control output (30), wherein the modulation microcontroller (28) is configured such that, for each half cycle of the carrier signal (2), when the carrier signal (2) is required to represent a ONE in a half cycle, the modulation microcontroller (28) does nothing until the end of this half cycle, and when it is required to mark a ZERO in a half cycle, the modulation microcontroller (28) sends a signal to the zero-control output (30) causing a zero switch (25) to close, thereby activating a first programmable attenuator configured as a voltage divider with a limiting resistor (22) and a zero attenuator assembly (27), which is configured to attenuate, for this half cycle, the sinusoidal signal of the carrier signal (2) to a level of magnitude lower than Vup if the half cycle is a positive half cycle or to a level of magnitude lower than Vun if the half cycle is a negative half cycle, wherein Vup is the minimum level of amplitude that defines a ONE in a positive half cycle and wherein Vun is the minimum level of amplitude that defines a ONE in a negative half cycle;
a synchrony control output (31), wherein the modulating microcontroller (28) is configured to generate a synchrony signal (5) by sending a signal to the synchrony control output (31) to momentarily close a sync switch (24), thereby activating a second programmable attenuator configured as a sync attenuator assembly (26), which is configured to cause a higher attenuation of the carrier signal (2) than the first attenuator to generate a synchrony signal (5) with a higher magnitude than a Vs level but lower than a Vs2 level, wherein the Vs level and the Vs2 level have magnitudes being greater than a zero level or a reference level but without exceeding Vup, wherein the modulator (50) is configured such that the synchronous signal (5) is added to the information (4) serial train of ONES and ZEROS; and
a modulation crystal (36) configured to allow the information (4) serial train frequencies and a frequency (23) of the carrier signal to remain always in agreement and in phase as a time reference;
wherein the demodulator (40) is configured to demodulate the modulated signal (3) and comprises:
a demodulation microcontroller (12), a set of positive (6) and negative (7) level comparators, and a zero-centering circuit (39) configured to establish a reference level located exactly between a maximum positive peak level and a maximum negative peak level of the modulated signal (3) to be demodulated; and
a demodulation crystal (32) configured to allow the demodulation microcontroller (12) to verify a synchrony status with a modulated signal (3), as a time reference, which allows the demodulation microcontroller (12) to present the transmitted information (4) serial train of ONES and ZEROS in an output (16) of the demodulator (40).

2. The synchronous modulation system using amplitude modulation according to claim 1, wherein the set of programmable attenuators (26, 27) comprises arrays of diodes, resistors and electronic switches (24, 25) controlled by the modulation microcontroller (28) to attenuate every half cycle of the carrier signal to a preset and constant level, so the modulation microcontroller (28) generates the information (4) serial train to be modulated and imprinted on the carrier signal (2) according to a program and the incoming information (4) serial train with the necessary attenuation levels recognizable by the demodulator (40).

3. The synchronous modulation system using amplitude modulation according to claims 1 and 2, wherein the demodulator (40) further comprises highspeed comparators (6, 7, 8, 49) connected to preset references and to the modulation signal (3) to be demodulated, so that upon detecting a level in each half cycle of the carrier signal (2), whether positive or negative, determines whether it is a ZERO, a ONE or a synchrony signal (5), communicating these evaluations directly to the demodulation microcontroller (12) by means of inputs provided for this purpose.

4. The synchronous modulation system using amplitude modulation according to claim 1, wherein the zero-centering circuit (39) comprises a positive rectifier (51) and a negative rectifier (52) connected to the demodulation microcontroller (12) which, based on rectified input signal values, varies the balance level of an amplifier (54), which in turn is connected to the modulation signal (3) and corrects any imbalance between the maximum positive peak value and the maximum negative peak value of the modulation signal (3).

## Patentansprüche

1. Synchrones Modulationssystem mit Amplitudenmodulation, das einen Modulator (50) und einen Demodulator (40) umfasst;
wobei der Modulator (50) Folgendes umfasst:
einen Modulationsmikrocontroller (28), der mit einem Synchronisierer (51) verbunden ist, der dazu konfiguriert ist, einen seriellen Zug von Informationen (4) von EINS und NULLEN in Bezug auf ein sinusförmiges Trägersignal (2) mit positiven und negativen Halbzyklen in Phase zu bringen und zu synchronisieren, um ein moduliertes Signal (3) zu generieren, wobei der Modulationsmikrocontroller (28) ferner dazu konfiguriert ist, einen Satz von programmierbaren Dämpfungsgliedern (26, 27) zu steuern, die dazu konfiguriert sind, jede EINS und jede NULL einer positiven oder einer negativen Hälfte des Trägersignals (2) zuzuordnen;
einen Nulldurchgangsdetektor (29), wobei ein Ausgang des Nulldurchgangsdetektors (29) mit einem Phasierungseingang (37) des Modulationsmikrocontrollers (28) verbunden ist, um eine Frequenz (23) des Trägersignals (2) und den seriellen Zug der Informationen (4) zu synchronisieren, die in den Modulationsmikrocontroller (28) eingegeben werden;
einen Null-Steuerungsausgang (30), wobei der Modulationsmikrocontroller (28) derart konfiguriert ist, dass für jeden Halbzyklus des Trägersignals (2), wenn das Trägersignal (2) eine EINS in einem Halbzyklus darstellen soll, der Modulationsmikrocontroller (28) bis zum Ende dieses Halbzyklus nichts tut, und wenn er eine NULL in einem Halbzyklus markieren soll, der Modulationsmikrocontroller (28) ein Signal an den Null-Steuerungsausgang (30) sendet, das das Schließen eines Null-Schalters (25) bewirkt, wodurch ein erstes programmierbares Dämpfungsglied aktiviert wird, das als Spannungsteiler mit einem Begrenzungswiderstand (22) und einer Null-Dämpfungsglied-Baugruppe (27) konfiguriert ist, die dazu konfiguriert ist, für diesen Halbzyklus das sinusförmige Signal des Trägersignals (2) auf einen Größenpegel, der niedriger als Vup ist, falls der Halbzyklus ein positiver Halbzyklus ist, oder auf einen Größenpegel abzuschwächen, der niedriger als Vun ist, falls der Halbzyklus ein negativer Halbzyklus ist, wobei Vup der minimale Amplitudenpegel ist, der eine EINS in einem positiven Halbzyklus definiert, und wobei Vun der minimale Amplitudenpegel ist, der eine EINS in einem negativen Halbzyklus definiert;
einen Synchronsteuerungsausgang (31), wobei der Modulationsmikrocontroller (28) dazu konfiguriert ist, ein Synchronsignal (5) zu generieren, indem ein Signal an den Synchronsteuerungsausgang (31) gesendet wird, um einen Synchronschalter (24) vorübergehend zu schließen, wodurch ein zweites programmierbares Dämpfungsglied aktiviert wird, das als eine Synchrondämpfungsglied-Baugruppe (26) konfiguriert ist, das dazu konfiguriert ist, eine höhere Dämpfung des Trägersignals (2) als das erste Dämpfungsglied zu bewirken, um ein Synchronsignal (5) mit einer höheren Größe als ein Vs-Pegel, aber niedriger als ein Vs2-Pegel zu generieren, wobei der Vs-Pegel und der Vs2-Pegel Größen aufweisen, die größer als ein Nullpegel oder ein Referenzpegel sind, aber Vup nicht überschreiten, wobei der Modulator (50) derart konfiguriert ist, dass das Synchronsignal (5) zu dem seriellen Zug von Informationen (4) von EINSEN und NULLEN hinzugefügt wird; und
einen Modulationskristall (36), der dazu konfiguriert ist, zu ermöglichen, dass die Frequenzen des seriellen Zuges von Informationen (4) und eine Frequenz (23) des Trägersignals als Zeitreferenz immer in Übereinstimmung und in Phase bleiben;
wobei der Demodulator (40) dazu konfiguriert ist, das modulierte Signal (3) zu demodulieren, und Folgendes umfasst:
einen Demodulationsmikrocontroller (12), einen Satz von Komparatoren für positive (6) und negative (7) Pegel, und eine Nullzentrierungsschaltung (39), die dazu konfiguriert ist, einen Referenzpegel einzurichten, der genau zwischen einem maximalen positiven Spitzenpegel und einem maximalen negativen Spitzenpegel des zu demodulierenden modulierten Signals (3) liegt; und
einen Demodulationsquarz (32), der dazu konfiguriert ist, dem Demodulationsmikrocontroller (12) zu ermöglichen, einen Synchronisationsstatus mit einem modulierten Signal (3) als Zeitreferenz zu verifizieren, der es dem Demodulationsmikrocontroller (12) ermöglicht, den seriellen Zug der übertragenen Informationen (4) von EINSEN und NULLEN in einem Ausgang (16) des Demodulators (40) zu präsentieren.

2. Synchrones Modulationssystem mit Amplitudenmodulation nach Anspruch 1, wobei der Satz von programmierbaren Dämpfungsgliedern (26, 27) Arrays von Dioden, Widerständen und elektronischen Schaltern (24, 25) umfasst, die von dem Modulationsmikrocontroller (28) gesteuert werden, um jeden Halbzyklus des Trägersignals auf einen voreingestellten und konstanten Pegel abzuschwächen, so dass der Modulationsmikrocontroller (28) den seriellen Zug von Informationen (4), die zu modulieren und dem Trägersignal (2) aufzuprägen sind, gemäß einem Programm und dem seriellen Zug von eingehenden Informationen (4) mit den erforderlichen Dämpfungspegeln generiert, die von dem Demodulator (40) erkennbar sind.

3. Synchrones Modulationssystem mit Amplitudenmodulation nach Anspruch 1 und 2, wobei der Demodulator (40) ferner Hochgeschwindigkeitskomparatoren (6, 7, 8, 49) umfasst, die mit voreingestellten Referenzen und mit dem zu demodulierenden Modulationssignal (3) verbunden sind, so dass beim Erkennen eines Pegels in jedem Halbzyklus des Trägersignals (2), ob positiv oder negativ, bestimmt wird, ob es eine NULL, eine EINS oder ein Synchronsignal (5) ist, wobei diese Auswertungen mittels für diesen Zweck bereitgestellten Eingängen direkt an den Demodulationsmikrocontroller (12) übermittelt werden.

4. Synchrones Modulationssystem mit Amplitudenmodulation nach Anspruch 1, wobei die Nullzentrierungsschaltung (39) einen positiven Gleichrichter (51) und einen negativen Gleichrichter (52) umfasst, die mit dem Demodulationsmikrocontroller (12) verbunden sind, der basierend auf gleichgerichteten Eingangssignalwerten den Ausgleichspegel eines Verstärkers (54) variiert, der wiederum mit dem Modulationssignal (3) verbunden ist und jedes Ungleichgewicht zwischen dem maximalen positiven Spitzenwert und dem maximalen negativen Spitzenwert des Modulationssignals (3) korrigiert.

## Revendications

1. Système de modulation synchrone utilisant la modulation d'amplitude et comprenant un modulateur (50) et un démodulateur (40) ;
dans lequel le modulateur (50) comprend :
un microcontrôleur de modulation (28) connecté à un synchroniseur (51) configuré pour mettre en phase et synchroniser un train sériel d'informations (4) de UNS et de ZÉROS par rapport à un signal porteur sinusoïdal (2) ayant des demi-cycles positif et négatif pour générer un signal modulé (3), dans lequel le microcontrôleur de modulation (28) est en outre configuré pour contrôler un ensemble d'atténuateurs programmables (26, 27) configurés pour associer chaque UN et chaque ZÉRO à un demi positif ou négatif du signal porteur (2) ;
un détecteur de passage à zéro (29), dans lequel une sortie du détecteur de passage à zéro (29) est connectée à une entrée de mise en phase (37) du microcontrôleur de modulation (28) pour synchroniser une fréquence (23) du signal porteur (2) et l'entrée du train sériel d'informations (4) dans le microcontrôleur de modulation (28) ;
une sortie de contrôle à zéro (30), dans lequel le microcontrôleur de modulation (28) est configuré de telle sorte que, pour chaque demi-cycle du signal porteur (2), lorsque le signal porteur (2) doit représenter un UN dans un demi-cycle, le microcontrôleur de modulation (28) ne fait rien jusqu'à la fin de ce demi-cycle, et lorsqu'il doit marquer un ZERO dans un demi-cycle, le microcontrôleur de modulation (28) envoie un signal à la sortie de contrôle à zéro (30) provoquant la fermeture d'un commutateur à zéro (25), activant ainsi un premier atténuateur programmable configuré comme un diviseur de tension avec une résistance de limitation (22) et un ensemble d'atténuateur au zéro (27), qui est configuré pour atténuer, pour ce demi-cycle, le signal sinusoïdal du signal porteur (2) à un niveau d'amplitude inférieur à Vup si le demi-cycle est un demi-cycle positif ou à un niveau de grandeur inférieur à Vun si le demi-cycle est un demi-cycle négatif, dans lequel Vup est le niveau minimum d'amplitude qui définit un UN dans un demi-cycle positif et dans lequel Vun est le niveau minimum d'amplitude qui définit un UN dans un demi-cycle négatif ;
une sortie de contrôle de synchronisation (31), dans lequel le microcontrôleur de modulation (28) est configuré pour générer un signal de synchronie (5) en envoyant un signal à la sortie de contrôle de synchronie (31) pour fermer momentanément un commutateur de synchronisation (24), activant ainsi un second atténuateur programmable configuré comme un ensemble d'atténuateurs de synchronisation (26), qui est configuré pour provoquer une atténuation plus élevée du signal porteur (2) que le premier atténuateur pour générer un signal de synchronie (5) d'une grandeur plus élevée à un niveau Vs mais plus faible à un niveau Vs2, dans lequel le niveau Vs et le niveau Vs2 ont des grandeurs étant supérieures à un niveau zéro ou à un niveau de référence mais sans dépasser Vup, dans lequel le modulateur (50) est configuré de telle sorte que le signal synchrone (5) est ajouté au train sériel d'informations (4) de UNS et de ZÉROS ; et
un cristal de modulation (36) configuré pour permettre aux fréquences de train sériel d'informations (4) et à une fréquence (23) du signal porteur de rester toujours en accord et en phase en tant que référence temporelle ;
dans lequel le démodulateur (40) est configuré pour démoduler le signal modulé (3) et comprend :
un microcontrôleur de démodulation (12), un ensemble de comparateurs de niveau positif (6) et négatif (7), et un circuit de centrage à zéro (39) configuré pour établir un niveau de référence situé exactement entre un niveau de crête positif maximal et un niveau de crête négatif maximal du signal modulé (3) à démoduler ; et
un cristal de démodulation (32) configuré pour permettre au microcontrôleur de démodulation (12) de vérifier un état de synchronie avec un signal modulé (3), en tant que référence temporelle, qui permet au microcontrôleur de démodulation (12) de présenter le train sériel d'informations (4) transmises sous la forme d'un train de UNS et de ZÉROS dans une sortie (16) du démodulateur (40).

2. Système de modulation synchrone utilisant la modulation d'amplitude selon la revendication 1, dans lequel l'ensemble d'atténuateurs programmables (26, 27) comprend des réseaux de diodes, des résistances et des commutateurs électroniques (24, 25) contrôlés par le microcontrôleur de modulation (28) pour atténuer chaque demi-cycle du signal porteur à un niveau prédéfini et constant, le microcontrôleur de modulation (28) génère donc le train sériel d'informations (4) à moduler et à imprimer sur le signal porteur (2) selon un programme et le train sériel d'informations (4) entrant avec les niveaux d'atténuation nécessaires reconnaissables par le démodulateur (40).

3. Système de modulation synchrone utilisant la modulation d'amplitude selon les revendications 1 et 2, dans lequel le démodulateur (40) comprend en outre des comparateurs à grande vitesse (6, 7, 8, 49) connectés à des références prédéfinies et au signal de modulation (3) à démoduler, de sorte que lors de la détection d'un niveau dans chaque demi-cycle du signal porteur (2), qu'il soit positif ou négatif, il détermine s'il s'agit d'un ZÉRO, d'un UN ou d'un signal de synchronie (5), communiquant ces évaluations directement au microcontrôleur de démodulation (12) au moyen d'entrées prévues à cet effet.

4. Système de modulation synchrone utilisant la modulation d'amplitude selon la revendication 1, dans lequel le circuit de centrage à zéro (39) comprend un redresseur positif (51) et un redresseur négatif (52) connectés au microcontrôleur de démodulation (12) qui, en fonction de valeurs de signal d'entrée redressé, varie le niveau d'équilibre d'un amplificateur (54), qui est à son tour connecté au signal de modulation (3) et corrige tout déséquilibre entre la valeur de crête positive maximale et la valeur de crête négative maximale du signal de modulation (3).
